(19) **Europäisches Patentamt / European Patent Office / Office européen des brevets**

(11) **EP 3 444 971 B1**

(12) **EUROPEAN PATENT SPECIFICATION**

(45) Date of publication and mention of the grant of the patent:
**09.12.2020 Bulletin 2020/50**

(21) Application number: **16901493.3**

(22) Date of filing: **20.10.2016**

(51) Int Cl.:
*H04B 10/25* (2013.01)      *H04B 10/524* (2013.01)
*H03K 7/02* (2006.01)      *H04J 14/02* (2006.01)
*H04B 10/079* (2013.01)      *H04B 10/54* (2013.01)
*H04L 25/49* (2006.01)

(86) International application number:
**PCT/CN2016/102741**

(87) International publication number:
**WO 2017/193538 (16.11.2017 Gazette 2017/46)**

(54) **SIGNAL GENERATION METHOD AND DEVICE**

SIGNALERZEUGUNGSVERFAHREN UND -VORRICHTUNG

PROCÉDÉ ET DISPOSITIF DE GÉNÉRATION DE SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.05.2016 CN 201610304100**

(43) Date of publication of application:
**20.02.2019 Bulletin 2019/08**

(73) Proprietor: **Huawei Technologies Co., Ltd.**
**Longgang District**
**Shenzhen, Guangdong 518129 (CN)**

(72) Inventors:
 • **FU, Shengmeng**
  **Shenzhen**
  **Guangdong 518129 (CN)**
 • **ZHANG, Hongguang**
  **Shenzhen**
  **Guangdong 518129 (CN)**
 • **MAN, Jiangwei**
  **Shenzhen**
  **Guangdong 518129 (CN)**
 • **GAO, Jianhe**
  **Shenzhen**
  **Guangdong 518129 (CN)**

(74) Representative: **Gill Jennings & Every LLP**
 **MTH**
 **The Broadgate Tower**
 **20 Primrose Street**
 **London EC2A 2ES (GB)**

(56) References cited:
 **EP-A2- 2 421 280      WO-A1-2014/130386**
 **CN-A- 103 840 882      US-A1- 2003 180 055**

 • "2.4 Signal Shot Noise" In: BOTTACCHI, S.: "Noise and Signal Interference in Optical Fiber Transmission Systems", 27 January 2009 (2009-01-27), XP009511053, pages 35-40, * , section 2.4.1.1, and figure 2.2 *
 • PRODANIUC, C. et al.: "56 Gb/s, PAM-4 Transmission Over 25 km, Using IQ Modulator and Unequally Spaced Levels", 2015 Conference on Lasers and Electro-Optics (CLEO), 13 August 2015 (2015-08-13), XP033194489,

**Description**

**TECHNICAL FIELD**

Embodiments of the present invention relate to the field of passive optical networks, and more specifically, to a signal generation method and device.

**BACKGROUND**

To meet a requirement of an access network for a rapid rate increase, a higher-order PAM modulation format is used, so that a system transmission rate can be improved while system costs and complexity are not increased. For a high-speed passive optical network (PON) system, to increase a power budget of the system, a receive end receives a PAM signal by using an avalanche photodiode (APD).

Noise generated by the APD in a working process is related to a signal strength and a signal amplitude. When the signal amplitude is fixed, a greater signal strength (or power) leads to greater noise. For a conventional multi-amplitude PAM signal, a plurality of level amplitudes are distributed at equal intervals (hereafter refered as equal-interval distribution). Therefore, if a PAM signal with equal-interval distribution is received by using the APD, there is a problem that a quality factor Q value between two adjacent high levels in an eye pattern consisting of the PAM signal is reduced and a bit error rate (Bit Error Rate, BER) of the system is increased.

In the prior art, to resolve the foregoing problem, a component for generating a multi-amplitude PAM signal with unequal-interval distribution is proposed, and can generate a PAM signal with unequal-interval distribution, so that an interval between two adjacent level amplitudes increases as the level amplitude increases. In this way, when the APD component receives a PAM signal with unequal-interval distribution, a Q value between two adjacent high levels is not reduced as the level amplitude increases, and the bit error rate of the system can be reduced.

Although a PAM signal with unequal-interval distribution is generated in the prior art, the PAM signal is obtained through rough estimation by human eyes with assistance of human adjustment. In other words, specific magnitude of level amplitudes of the PAM signal with unequal-interval distribution cannot be determined in the prior art.

US2003180055 describes a amplitude modulated optical communication system and method that achieve bandwidth compression by making use of an n level amplitude modulation scheme in one or more frequency bands. The optical signal generated by a light source is monitored and a calibration scheme compensates for the non-linear effects of the light source. When the optical signal is monitored by a photo-detector at a remote receiver, the present invention compensates for the non-linear effects of the channel as well. A calibration circuit adjusts the current (or voltage) that is applied to the light source for a given signal level in the multiple level transmission scheme to thereby compensate for the non-linear effects.

WO 2014/130386 describes an apparatus which includes an optical transmitter configured to provide an optical signal amplitude-modulated among M different levels. A constellation control module is configured to provide a drive signal to control the optical signal. A feedback module is configured to receive a measure of spacing between amplitude peaks of a symbol constellation of the optical signal. The feedback module is further configured to regulate the constellation control module to adjust the optical signal in response to the measure of spacing.

EP2421280 describes systems and methods to provide an upstream rate between 1Gbps and 10Gbps in a cost effective manner in a 10GEPON. An optical network unit (ONU) transmitter includes a burst transceiver and a physical layer (PHY) including a high performance digital to analog converter (DAC), a pulse amplitude modulation (PAM) module configured to encode end user data using a modulation scheme having more than two levels, and a laser. The ONU transmitter transmits the encoded end user data to an optical line terminal (OL T) receiver, which demodulates the data using a PAM demodulator and sends it to a service provider.

**SUMMARY**

This application provides a signal generation method and device, so that specific magnitude of level amplitudes of a PAM signal with unequal-interval distribution can be determined during generation of the PAM signal.

According to a first aspect, there is provided a method according to appended claim 1.

According to a second aspect, there is provided a device according to appended claim 5.

According to a third aspect, there is provided a network according to appended claim 10.

According to the signal generation method and device provided in this application, the signal receive end device feeds back information of the received PAM signal to the signal transmit end device, so that the signal transmit end device can determine specific magnitude of level amplitudes of a PAM signal with unequal-interval distribution during generation of the PAM signal.

**BRIEF DESCRIPTION OF DRAWINGS**

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.

FIG. 1 is a schematic interaction diagram of a signal generation method according to an embodiment of the present invention;

FIG. 2 is a schematic diagram of a multi-amplitude PAM signal according to an embodiment of the present invention;

FIG. 3 is a flowchart of determining target level amplitudes of a PAM4 signal with unequal-interval distribution;

FIG. 4 shows an APD-ROSA component model;

FIG. 5 is a schematic diagram of application of a signal generation method to a PON network according to an embodiment of the present invention;

FIG. 6 shows an example of a schematic interaction diagram of an OLT and an ONU;

FIG. 7 shows another example of a schematic interaction diagram of an OLT and an ONU;

FIG. 8 is a schematic block diagram of a signal transmit end device 500 according to an embodiment of the present invention;

FIG. 9 is a schematic block diagram of a signal receive end device 600 according to an embodiment of the present invention;

FIG. 10 is a schematic structural diagram of a signal transmit end device 700 according to an embodiment of the present invention; and

FIG. 11 is a schematic structural diagram of a signal receive end device 800 according to an embodiment of the present invention.

**DESCRIPTION OF EMBODIMENTS**

The following clearly and completely describes the technical solutions in the embodiments of the present invention with reference to the accompanying drawings in the embodiments of the present invention. Apparently, the described embodiments are some but not all of the embodiments of the present invention. All other embodiments obtained by a person of ordinary skill in the art based on the embodiments of the present invention without creative efforts shall fall within the protection scope of the present invention.

A signal generation method in the embodiments of the present invention is applicable to various multi-amplitude PAM signal, such as PAM4, PAM8, and PAM16. For ease of understanding and description, the signal generation method according to the embodiments of the present invention is described only by using PAM4 as an example in the embodiments of the present invention.

It should be understood that, in the embodiments of the present invention, serial numbers "first" and "second" are merely used to distinguish different objects, for example, to distinguish different PAM signals or different level amplitudes, and shall not constitute any limitation on the protection scope of the embodiments of the present invention.

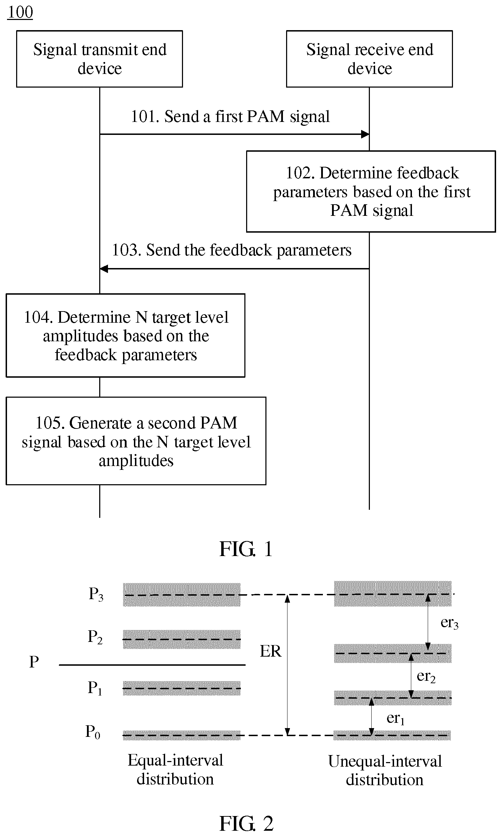

FIG. 1 is a schematic interaction diagram of a signal generation method 100 according to an embodiment of the present invention. As shown in FIG. 1, the method 100 includes the following steps.

101. A signal transmit end device sends a first PAM signal to a signal receive end device.

Specifically, the first PAM signal includes N first level amplitudes, and N≥3. For example, when N=4, the first PAM signal is a PAM4 signal. For another example, when N=8, the first PAM signal is a PAM8 signal.

It may be understood that, when N=2, a PAM signal includes two level amplitudes, and does not involve an issue of distributing the level amplitudes at unequal intervals. Therefore, in the method for generating a multi-amplitude PAM signal with unequal-interval distribution according to this embodiment of the present invention, a minimum value of N is 3.

In this embodiment of the present invention, the N first level amplitudes included by the first PAM signal may be distributed at equal intervals, or distributed at unequal intervals.

It should be noted that the first PAM signal sent by the signal transmit end device to the signal receive end device may be generated by using a method in the prior art. For brevity, no description is provided herein.

It should be understood that the first PAM signal and a second PAM signal include a same quantity of levels. To be specific, according to the signal generation method in this embodiment of the present invention, if a PAM signal (denoted as a PAM signal #1 for ease of differentiation and description) with unequal-interval distribution needs to be generated, first, the signal transmit end device needs to generate a PAM signal (denoted as a PAM signal #2 for ease of differentiation and description) that includes a same quantity of level amplitudes, and sends the PAM signal #2 to the signal receive end device; then, the signal receive end device feeds back information of the PAM signal #2 to the signal transmit end device, so that the signal transmit end device adjusts (or optimizes) the PAM signal #2, and finally generates the PAM signal #1. A process in which the signal transmit end device adjusts the PAM signal #2 is a process of determining level amplitudes of the PAM signal #1. Therefore, specific magnitude of the level amplitudes of the finally generated PAM signal #1 is known. In other words, according to the signal generation method in this embodiment of the present invention, a PAM signal of which level amplitudes are distributed at unequal intervals and have known specific magnitude can be generated.

102. The signal receive end device determines feedback parameters based on the first PAM signal.

In this embodiment of the present invention, the signal receive end device determines the feedback parameters in two situations.

Situation 1

An average power P and an extinction ratio ER of N first levels corresponding to the N first level amplitudes included by the first PAM signal are determined.

It should be noted that the average power P is an average of powers of a plurality of levels included by the PAM signal. The extinction ratio ER is a ratio of a level power of a highest level to a level power of a lowest level in the N first levels included by the first PAM signal.

For example, if powers of four level included by a PAM4 signal are successively denoted as $P_0$, $P_1$, $P_2$, and $P_3$ in ascending order, $P=(P_0+P_1+P_2+P_3)/4$, and an ER may be represented as $ER=P_3/P_0$. For another example, if powers of eight level included by a PAM8 signal are successively denoted as $P_0$, $P_1$, $P_2$, ..., and $P_7$ in ascending order, $P=(P_0+P_1+...+P_7)/8$, and ER may be represented as $ER=P_7/P_0$.

The signal receive end device may detect the received first PAM signal, to obtain an average power and an ER of the first PAM signal.

Situation 2

A maximum level power and a minimum level power in powers of N first levels included by the first PAM signal are determined.

Specifically, the signal receive end device may determine a maximum power (namely, the maximum level power) and a minimum power (namely, the minimum level power) by using the prior art. For brevity, details are not described herein. For example, in a time period in which the signal receive end device receives the first PAM signal sent by the signal transmit end device, the signal receive end device may detect the first PAM signal by using a high-speed photodiode (Photo Diode, PD), to obtain the maximum power and the minimum power through detection.

103. The signal transmit end device receives the feedback parameters sent by the signal receive end device.

Specifically, the signal transmit end device may receive, in a plurality of manners, the feedback parameters sent by the signal receive end device. For example, the signal receive end device may perform, based on a preset agreement in a system, feedback upon reception of the PAM signal. Alternatively, the signal receive end device may report the feedback parameters to the signal transmit end device after receiving a report request from the signal transmit end device. This embodiment of the present invention sets no special limitation thereto.

104. The signal transmit end device determines N target level amplitudes based on the feedback parameters.

It should be understood that the N target level amplitudes herein are N level amplitudes of a PAM signal that the signal transmit end device needs to finally generate, to be specific, N level amplitudes of the second PAM signal.

Optionally, in an embodiment, that the signal transmit end device determines N target level amplitudes based on the feedback parameters includes:

the signal transmit end device generates N reference level amplitudes based on the feedback parameters and preset parameters;
the signal transmit end device determines a quality factor between every two adjacent reference level amplitudes in the N reference level amplitudes, to obtain (N-1) quality factors; and
when a difference between any two quality factors in the (N-1) quality factors is less than or equal to a preset threshold, the signal transmit end device determines the N reference level amplitudes as the N target level amplitudes.

The following describes a specific process of determining the target level amplitudes in this embodiment of the present invention in detail.

For ease of understanding, parameters in this embodiment of the present invention are first briefly described with reference to FIG. 2 by using a PAM4 signal as an example.

FIG. 2 is a schematic diagram of a multi-amplitude PAM signal according to an embodiment of the present invention. As shown in FIG. 2, a PAM4 signal includes four levels (or four level amplitudes), and powers of the four levels are successively $P_0$, $P_1$, $P_2$, and $P_3$ in ascending order. P is an average power of the four powers. An extinction ratio ER represents a ratio of a maximum power to a minimum power in the powers corresponding to the four levels included by the PAM4 signal.

In a transmission process of the multi-amplitude PAM signal, a crosstalk degree between every two adjacent levels may be measured by using a ratio (to be specific, an extinction ratio of sub-eyes in an eye pattern consisting of the PAM signal) of powers of the two adjacent levels. A larger "sub-eye" and a more regular eye pattern indicate smaller intersymbol crosstalk, and on the contrary, greater intersymbol crosstalk.

For example, an extinction ratio between $P_1$ and $P_0$ is $er_1$, and an extinction ratio between $P_2$ and $P_1$ is $er_2$.

It can be known based on the foregoing description of the parameters that the parameters meet the following relational expressions:

$$P=(P_0+P_1+P_2+P_3)/4 \qquad (1);$$

$$ER=P_3/P_0 \qquad (2);$$

$$er_1=P_1/P_0 \qquad (3);$$

$$er_2=P_2/P_1 \qquad (4);$$

$$er_3=P_3/P_2 \qquad (5);$$

and

$$ER=er_1 \times er_2 \times er_3 \qquad (6).$$

It can be known based on a relationship among the foregoing parameters that a relationship between P and $P_0$ may be represented as:

$$P_0=4 \times P/(1+er_1+ER/ER+er_3).$$

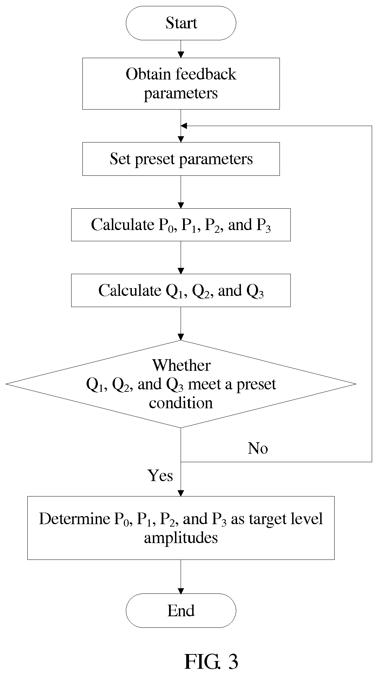

How to determine the target level amplitudes is described in detail below with reference to FIG. 3.

It should be understood that, in this embodiment of the present invention, the target level amplitudes are a plurality of level amplitudes included by an optimal PAM signal that meets a current network status and is determined by a system. In other words, if specific magnitude of level amplitudes included by a multi-amplitude PAM signal with unequal-interval distribution is determined, the multi-amplitude PAM signal with unequal-interval distribution is determined.

A process of determining the target level amplitudes is described in detail below with reference to FIG. 3.

FIG. 3 is a flowchart of determining target level amplitudes of a PAM4 signal with unequal-interval distribution. As shown in FIG. 3, a process in which a signal transmit end device determines target level amplitudes mainly includes the following steps.

(1) Obtain feedback parameters.

Specifically, the signal transmit end device may receive P and ER fed back by a signal receive end device. Alternatively, the signal transmit end device may receive $P_3$ and $P_0$ fed back by a signal receive end device.

(2) Set preset parameters.

If the signal receive end device reports P and ER to the signal transmit end device, the signal receive end device may set values of any two parameters of $P_0$, $P_1$, $P_2$, $P_3$, $er_1$, $er_2$, and $er_3$. In other words, initial values are set for any two of the seven parameters.

Specifically, in a process of setting the initial values, if initial values of $er_1$, $er_2$, and $er_3$ are to be set, the specified initial values need to be less than ER; and if initial values of $P_0$, $P_1$, $P_2$, and $P_3$ are to be set, specified magnitude of $P_0$

and $P_1$ needs to be less than P, and specified magnitude of $P_2$ and $P_3$ needs to be greater than P.

It should be understood that a magnitude relationship between the foregoing preset parameters may be used as a preferred manner. The signal generation method in this embodiment of the present invention is used for generating a PAM signal with unequal-interval distribution, and when level amplitudes increase, an interval between the level amplitudes also needs to increase, so that a Q value between adjacent levels is not reduced. Therefore, the level amplitudes are preferentially set to an average location, so that magnitude of the target level amplitudes can be determined more quickly.

If the signal receive end device feeds back a maximum power $P_3$ and a minimum power $P_0$, the signal receive end device may set values of any two parameters of $er_1$, $er_2$, and $er_3$.

For example, the signal transmit end device sets initial values of $er_1$ and $er_3$. It can be known based on the relational expressions (1) to (5) that, $P_1=P_0 \times er_1$ and $P_2=P_3/er_3$. Therefore, the signal transmit end device may obtain specific values of $P_0$, $P_1$, $P_2$, and $P_3$ through calculation.

It may be understood that, during implementation of the present invention, the signal transmit end device may specifically determine, based on the feedback parameters sent by the signal receive end device, which parameters are to be set as the preset parameters.

For example, when the feedback parameters are an average power and an extinction ratio ER, it can be known based on the foregoing relational expressions (1) to (5) that, an equation set consisting of the relational expressions (1) to (5) includes five equations and seven parameters, and the seven parameters are respectively $P_0$, $P_1$, $P_2$, $P_3$, $er_1$, $er_2$, and $er_3$ (because P and ER are known). If values of $P_0$, $P_1$, $P_2$, and $P_3$ need to be obtained through calculation, actually only two parameters need to be randomly selected from the foregoing seven parameters, initial values of the two parameters are set, and an equation set including five equations and five parameters is obtained. In this case, the equation set has a unique solution. Therefore, when the feedback parameters are the average power P and the extinction ratio ER, the preset parameters may be any two of the foregoing seven parameters of $P_0$, $P_1$, $P_2$, $P_3$, $er_1$, $er_2$, and $er_3$.

For another example, when the feedback parameters are the maximum power $P_3$ and the minimum power $P_0$, it can be known based on the foregoing relational expressions (1) to (5) that, $P_1=P_0 \times er_1$ and $P_2=P_3/er_3$. Because $P_3$ and $P_0$ are known, the specific values of $P_0$, $P_1$, $P_2$, and $P_3$ can be obtained through calculation only by setting $er_1$ and $er_3$ as the preset parameters and setting initial values of $er_1$ and $er_3$.

A process of calculating powers of levels of the PAM4 signal based on the feedback parameters and the preset parameters is described in detail above only by using PAM4 as an example. A process of calculating a PAM signal with other amplitudes such as PAM8 and PAM16 is similar. For brevity, details are not described herein again.

(3) Calculate reference level amplitudes based on the feedback parameters and the preset parameters.

After setting the initial values of the preset parameters, the signal transmit end device may obtain powers $P_0$, $P_1$, $P_2$, and $P_3$ corresponding to reference levels through calculation based on the foregoing relational expressions (1) to (5).

It should be noted that specific magnitude of level amplitudes may be determined by calculating powers of levels included by a PAM signal. If the powers of the levels of the PAM signal are determined, the level amplitudes of the PAM signal are determined, and the PAM signal is determined.

As described above, for calculation of the reference level amplitudes (or calculation of the powers of the reference levels), the signal receive end device may feed back the average power P and the extinction ratio ER of the first PAM signal to the signal transmit end device, or feed back the maximum power and the minimum power to the signal transmit end device. The signal transmit end device may obtain $P_0$, $P_1$, $P_2$, and $P_3$ through calculation based on the feedback parameters sent by the signal receive end device.

It should be understood that $P_0$, $P_1$, $P_2$, and $P_3$ herein may be corresponding to the reference level amplitudes in this embodiment of the present invention. The signal transmit end device may obtain the target level amplitudes by adjusting reference levels.

(4) Calculate quality factors $Q_1$, $Q_2$, and $Q_3$ between every two adjacent reference level amplitudes.

The signal transmit end device calculates a Q value between every two adjacent reference level amplitudes. PAM4 is used as an example. There are four reference level amplitudes, and a Q value between every two adjacent amplitudes is calculated, to obtain three Q values: $Q_1$, $Q_2$, and $Q_3$.

It may be understood that a quantity of Q values is corresponding to a quantity of level amplitudes included by the PAM signal. For example, PAM8 includes eight level amplitudes, and one Q value is obtained through calculation between every two adjacent level amplitudes. Therefore, seven Q values are obtained through calculation. Similarly, for PAM16, 15 Q values are obtained through calculation.

It should be noted that, during implementation of the present invention, two adjacent level amplitudes means being adjacent in terms of level amplitudes. For example, if amplitudes of four levels of the PAM4 signal are respectively $A_1$, $A_2$, $A_3$, and $A_4$, and $0<A_1<A_2<A_3<A_4$, $A_1$ and $A_2$ are adjacent level amplitudes, $A_2$ and $A_3$ are adjacent level amplitudes, and $A_3$ and $A_4$ are adjacent level amplitudes.

(5) Determine whether differences among $Q_1$, $Q_2$, and $Q_3$ are less than a preset threshold.

The signal transmit end device determines the plurality of Q values obtained through calculation, and determines whether a difference between every two Q values is less than or equal to the preset threshold (namely, a preset condition in FIG. 3).

It should be understood that, in this embodiment of the present invention, the preset threshold is a tiny reference value that is set by the signal transmit end device. When absolute values of the differences among $Q_1$, $Q_2$, and $Q_3$ are less than or equal to the reference value, a PAM signal output by the signal transmit end device in this case is an optimal signal of a current link.

(6) If the differences among $Q_1$, $Q_2$, and $Q_3$ are less than or equal to the preset threshold, determine $P_0$, $P_1$, $P_2$, and $P_3$ as the target level amplitudes.

When the absolute values of the differences among $Q_1$, $Q_2$, and $Q_3$ are less than or equal to the preset threshold, $P_0$, $P_1$, $P_2$, and $P_3$ are determined as the target level amplitudes. In other words, the signal transmit end device outputs a second PAM4 signal, and powers of four levels of the second PAM4 signal are respectively $P_0$, $P_1$, $P_2$, and $P_3$.

(7) If the differences among $Q_1$, $Q_2$, and $Q_3$ are greater than the preset threshold, reset preset parameters.

It should be understood that, if the differences among $Q_1$, $Q_2$, and $Q_3$ are greater than the preset threshold, it indicates that Q values of an eye pattern consisting of the reference level amplitudes $P_0$, $P_1$, $P_2$, and $P_3$ are not optimal. Therefore, initial values of preset parameters need to be reset, and a group of new reference level amplitudes need to be obtained through calculation based on the reset preset parameters. Steps (2) to (5) in the foregoing process are repeated, until a group of reference level amplitudes meeting the preset threshold are obtained. A calculation process after the preset parameters are reset is the same as the foregoing steps (2) to (5), and details are not described herein again.

It should be understood that parameters P and ER in the foregoing relational expressions (1) to (5) may be obtained as reported by a signal receive end device. Therefore, there are seven parameters in the relational expressions (1) to (5) in total: $P_0$, $P_1$, $P_2$, $P_3$, $er_1$, $er_2$, and $er_3$. In other words, there are seven parameters and five equations. To make an equation set consisting of the foregoing five equations have a unique solution, it only requires to make a quantity of equations be equal to a quantity of unknown parameters. Therefore, provided that initial values are set for any two of the seven parameters $P_0$, $P_1$, $P_2$, $P_3$, $er_1$, $er_2$, and $er_3$, and the foregoing relational expressions (1) to (5), P, and ER are used, the signal transmit end device can obtain specific values of the foregoing four powers $P_0$, $P_1$, $P_2$, and $P_3$.

After the specific values of $P_0$, $P_1$, $P_2$, and $P_3$ are obtained, a Q value between powers (for example, $P_1$ and $P_0$, $P_2$ and $P_1$, and $P_3$ and $P_2$) of every two adjacent levels may be calculated. When a difference between the Q values is less than or equal to the preset threshold, a second PAM signal with unequal-interval distribution is generated.

Specifically, the Q values need to be obtained through calculation based on working parameters of a receiver component: an avalanche photodiode-receiver optical subassembly (APD-ROSA).

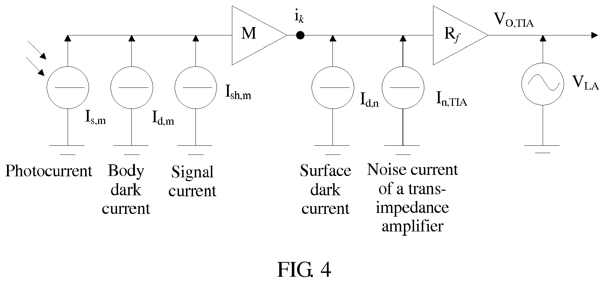

A working model of the APD-ROSA and how to obtain the Q value between every two adjacent levels through calculation based on the working parameters of the APD-ROSA are described in detail below with reference to FIG. 4.

FIG. 4 shows an APD-ROSA component model. As shown in FIG. 4, noise of an APD-ROSA (APD for short below) mainly comes from shot noise of the APD, body dark current noise of the APD, surface dark current noise of the APD, and thermal noise of a trans-impedance amplifier (TIA).

A noise current $\sigma_k$ generated by the APD for optical signals of different signal strengths may be obtained through calculation based on the APD component model shown in FIG. 4 by using a relational expression (7):

$$\sigma_k = \sqrt{2q \times M^2 \times F \times BW_n \times i_{sh,m} + 2q \times M^2 \times F \times BW_n \times i_{d,m} + \overline{i^2_{d,n}} + \overline{i^2_{n,TIA}} + \left(\frac{\overline{v_{LA}}}{R_f}\right)^2} \quad (7).$$

Physical meanings of parameters in the relational expression (7) are as follows:

$i_{sh,m} = M \times P_k \times R$ is a signal current generated after an optical signal with a signal power of $P_k$ passes through the APD;

$i_{d,m}$ is a body dark current of the APD;

$i_{d,n}$ is a surface dark current of the APD, and $i_{n,TIA}$ is noise of the TIA;

$\left(\dfrac{\overline{v_{LA}}}{R_f}\right)^2$ is noise of a post amplifier inside the ROSA;

q is an electron charge constant, M is a multiplication factor of the APD, F is an excess noise factor of the APD, R is an intrinsic responsivity of the APD, $BW_n$ is bandwidth of the APD, $n_{LA}$ is an equivalent input noise voltage of the post amplifier, and $R_f$ is a reference resistance of the post amplifier.

Parameters such as M, F, R, $BW_n$, $n_{LA}$, and $R_f$ are intrinsic properties of the APD component, and may be obtained from a parameter list of the APD component.

The Q values between two adjacent levels may be obtained through calculation with reference to the relational expression (7) by using a relational expression (8):

$$Q_k = \frac{i_k - i_{k-1}}{\sigma_k + \sigma_{k-1}} \quad (8).$$

In the expression (8), $i_k$ represents a signal current of a $k^{th}$ level of a multi-amplitude PAM signal, and $\sigma_k$ represents a noise current of the $k^{th}$ level.

It can be known based on the foregoing description that, after obtaining the power of each level of the PAM signal through calculation, the signal transmit end device may obtain a noise current of each level based on the relational expression (7), and obtain values of $Q_1$, $Q_2$, and $Q_3$ through calculation based on the relational expression (8).

105. The signal transmit end device generates a second PAM signal based on the N target level amplitudes.

Generating the second PAM signal based on the N target level amplitudes is using the N determined target level amplitudes as level amplitudes of the second PAM signal.

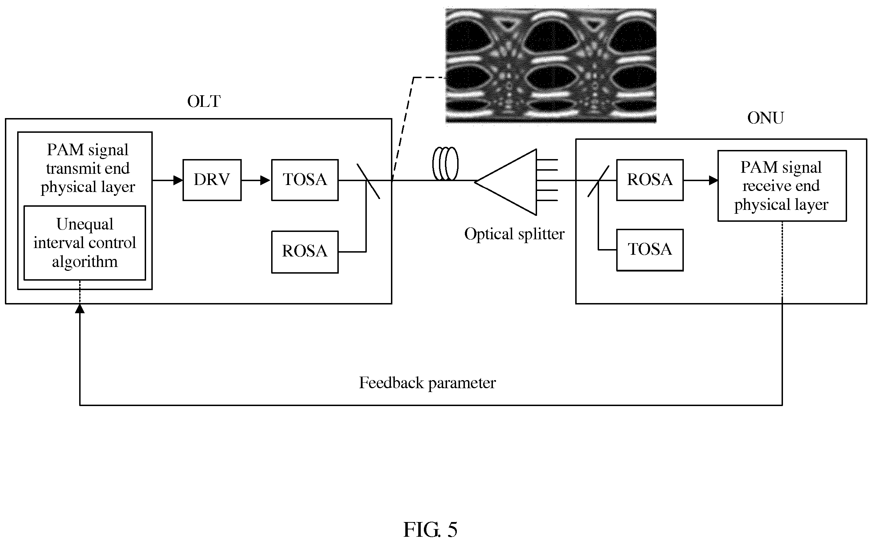

FIG. 5 is a schematic diagram of application of a signal generation method to a PON network according to an embodiment of the present invention. As shown in FIG. 5, an optical line terminal (OLT) includes a transmitter optical subassembly (TOSA), a receiver optical subassembly (ROSA), a driver (DRV), and a transmit end physical layer at which a PAM signal unequal interval control algorithm runs. The unequal interval control algorithm is used to adjust a PAM signal output by the OLT (or adjust an eye pattern consisting of the PAM signal), to generate a PAM signal with unequal-interval distribution. An optical network unit (ONU) includes a TOSA, a ROSA, and a PAM signal receive end physical layer. In the PON network, an ONU detects an average power P and an extinction ratio ER of a received PAM signal, and reports such information to the OLT. The OLT adjusts amplitudes of a multi-amplitude PAM signal by using the unequal interval control algorithm based on the information of P and ER reported by the ONU, to output an unequal-interval PAM signal. Because P and ER detected by the ONU are real information obtained after the PAM signal is transmitted in the network, the OLT may output an optimal PAM signal by optimizing the signal based on the information.

It should be noted that, the unequal interval control algorithm herein may be corresponding to a process of determining the target level amplitudes based on the feedback parameters and the preset parameters in this embodiment of the present invention.

Optionally, in an embodiment, before the signal transmit end device obtains the feedback parameters, the method further includes:

the signal transmit end device sends a report request to the signal receive end device, where the report request is used to instruct the signal receive end device to report the feedback parameters.

In this embodiment of the present invention, the signal receive end device may send the feedback parameters to the signal transmit end device in a pre-agreed manner, or after receiving the report request of the signal transmit end device, the signal receive end device may send the feedback parameters to the signal transmit end device based on the report request.

In this embodiment of the present invention, the signal receive end device feeds back information (namely, the feedback parameters) of the received first PAM signal to the signal transmit end device, so that the signal transmit end device may obtain the second PAM signal through calculation based on the feedback parameters. In other words, specific magnitude of level amplitudes of the second PAM signal can be determined during generation of a PAM signal (namely, the second PAM signal) with unequal-interval distribution.

In this embodiment of the present invention, the PON network is specifically in two network forms: a broadcast-type network and a non-broadcast-type network.

The following describes application of the signal generation method in this embodiment of the present invention to the broadcast-type network and the non-broadcast-type network separately.

Broadcast-type network

For the broadcast-type network, an OLT (to be specific, an example of a signal transmit end device) sends a first PAM signal to all ONU (to be specific, an example of a signal receive end device) users in the network. Correspondingly, each ONU user in the network sends feedback parameters to the OLT. It is assumed that there are M ONU users in the network, and M≥2. The OLT receives M groups of feedback parameters. If the feedback parameters sent by the ONU user to the OLT are an average power P and an extinction ratio ER, the OLT needs to select, from the M groups of feedback parameters, a group of parameters with a minimum P value, and adjusts and optimizes the first PAM signal, to generate a second PAM signal.

It may be understood that, when an ONU (denoted as an ONU #1 for ease of description) corresponding to the group of parameters with the minimum average power P value can receive a PAM signal sent by the OLT, another ONU in the network can also receive the PAM signal sent by the OLT.

Non-broadcast-type network

For the non-broadcast-type network, an OLT needs to send a particular PAM signal to a particular ONU. Different ONUs send PAM signals through time division multiplexing. In other words, the OLT sends only one PAM signal to a particular ONU in each time period.

It may be understood that, when the OLT sends a PAM signal to each ONU, the OLT needs to adjust and optimize the PAM signal based on feedback parameters of each ONU, and sends the adjusted and optimized PAM signal to the corresponding ONU.

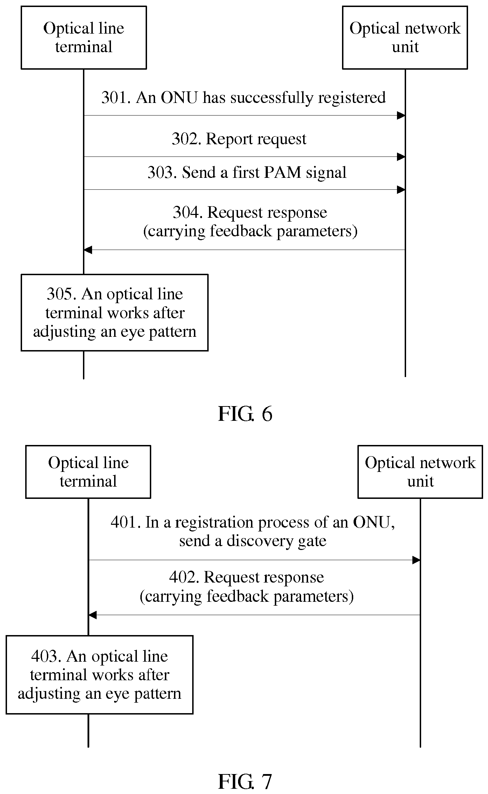

The following describes a process of information interaction between an OLT and an ONU with reference to FIG. 6 and FIG. 7.

FIG. 6 shows an example of a schematic interaction diagram of an OLT and an ONU. As shown in FIG. 6, a process of information interaction between the OLT and the ONU mainly includes step 301 to step 305.

301. An ONU has successfully registered.

It should be understood that, in a PON network, an ONU user first needs to register with the PON network before working.

302. An OLT sends a report request to the ONU.

In this embodiment of the present invention, the ONU needs to feed back information of a received PAM signal to the OLT. In a specific implementation process, the OLT may first add, to a downlink operation, administration and maintenance (OAM) message or a multi-point control protocol (MPCP) message, a command of requiring the ONU to report an average optical power and an extinction ratio received by the ONU (or report a maximum optical power value and a minimum optical power value). Information reported by the ONU includes at least three information fields: an ONU identifier, an extinction ratio ER, and an average optical power.

It should be understood that the ONU identifier is used to indicate an ONU, in the PON network, that needs to report feedback parameters.

303. The OLT sends a PAM signal #1 to the ONU.

It should be understood that the PAM signal #1 herein is a multi-amplitude PAM signal that is sent to the ONU user before the OLT adjusts an eye pattern, so that the ONU user feeds back information (for example, an average power and an extinction ratio, or a maximum power value and a minimum power value) of the received PAM signal #1, to optimize parameters of the PAM signal #1.

It should be understood that there is no sequence for step 302 and step 303, and a sequence herein shall not constitute any limitation on the protection scope of the signal generation method in this embodiment of the present invention. For example, step 303 may be performed first, and then step 302 is performed.

304. The ONU sends a request response message to the OLT, where the request response message carries feedback parameters.

305. The OLT works after adjusting an eye pattern.

Specifically, the OLT adjusts (or optimizes) the parameters (for example, level amplitudes or an extinction ratio between adjacent level amplitudes) of the PAM signal #1 based on the feedback parameters reported by the ONU in step 304, determines a current working status, and outputs a PAM signal #2.

It should be understood that magnitude of adjusted level amplitudes is determined as magnitude of level amplitudes included by the PAM signal #2.

FIG. 7 shows another example of a schematic interaction diagram of an OLT and an ONU. As shown in FIG. 7, a process of information interaction between the OLT and the ONU mainly includes step 401 to step 403.

401. In a registration process of an ONU, an OLT sends a discovery gate to the ONU.

It can be known from the foregoing description that, the ONU first needs to register with a PON network before working. For ease of understanding and description, it is assumed that the ONU in the registration process is an ONU #1. Then, in a registration process of the ONU #1, the OLT sends a discovery gate to all ONUs in the network, to instruct another ONU other than the ONU #1 to stop reporting feedback parameters in a time period corresponding to the discovery gate, so that the time period corresponding to the discovery gate is used for reporting of the ONU #1 only.

402. The ONU sends a request response message to the OLT, where the request response message carries feedback parameters.

It should be understood that, after the ONU #1 performs successful registration, the ONU #1 may receive a multi-amplitude PAM signal sent by the OLT, and report information (for example, an average power and an extinction ratio, or a maximum power value and a minimum power value) of the received multi-amplitude PAM signal, so that the OLT adjusts and optimizes the multi-amplitude PAM signal based on the information reported by the ONU #1, and outputs the adjusted PAM signal.

403. The OLT works after adjusting an eye pattern.

It may be understood that, the OLT optimizes the PAM signal based on the information reported by the ONU #1, and outputs the optimized PAM signal.

According to the signal generation method in this embodiment of the present invention, a Q factor of the PAM signal can be improved, and a BER of a system can be reduced, thereby finally improving receiver sensitivity of the system and increasing a power budget of the system.

It should be understood that, in FIG. 6 and FIG. 7, the OLT is an example of a signal transmit end device, and the ONU is an example of a signal receive end device.

In this embodiment of the present invention, the signal receive end device feeds back information (namely, the feedback parameters) of the received first PAM signal to the signal transmit end device, so that the signal transmit end device may obtain the second PAM signal through calculation based on the feedback parameters. In other words, specific magnitude of level amplitudes of the second PAM signal can be determined during generation of a PAM signal (namely, the second PAM signal) with unequal-interval distribution.

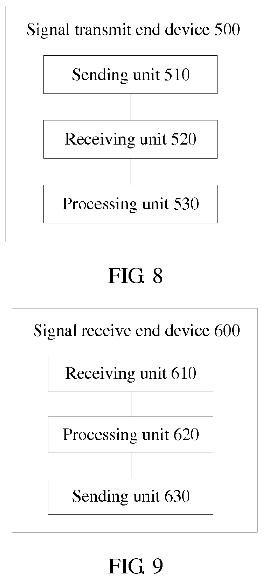

The foregoing describes the signal generation method according to the embodiments of the present invention in detail with reference to FIG. 1 to FIG. 7. The following describes a signal transmit end device and a signal receive end device according to embodiments of the present invention with reference to FIG. 8 and FIG. 9.

FIG. 8 is a schematic block diagram of a signal transmit end device 500 according to an embodiment of the present invention. As shown in FIG. 8, the signal transmit end device 500 includes:

a sending unit 510, configured to send a first PAM signal to a signal receive end device, where the first PAM signal includes N first level amplitudes, and $N \geq 3$;

a receiving unit 520, configured to receive feedback parameters sent by the signal receive end device, where the feedback parameters are determined by the signal receive end device based on the first PAM signal; and

a processing unit 530, configured to determine N target level amplitudes based on the feedback parameters, where intervals between every two adjacent target level amplitudes in the N target level amplitudes are different from each other, where

the processing unit 530 is further configured to generate, based on the N target level amplitudes, a second PAM signal that needs to be sent to the signal receive end device.

The units in the signal transmit end device 500 according to this embodiment of the present invention and the foregoing other operations or functions are separately for implementing a corresponding process executed by the signal transmit end device in the method 100. For brevity, details are not described herein again.

Therefore, in this embodiment of the present invention, the signal receive end device feeds back information (namely, the feedback parameters) of the received first PAM signal to the signal transmit end device, so that the signal transmit end device may obtain the second PAM signal through calculation based on the feedback parameters. In other words, specific magnitude of level amplitudes of the second PAM signal can be determined during generation of a PAM signal (namely, the second PAM signal) with unequal-interval distribution.

FIG. 9 is a schematic block diagram of a signal receive end device 600 according to an embodiment of the present invention. As shown in FIG. 9, the signal receive end device 600 includes:

a receiving unit 610, configured to receive a first PAM signal sent by a signal transmit end device, where the first PAM signal includes N first level amplitudes, and $N \geq 3$;

a processing unit 620, configured to determine feedback parameters based on the first PAM signal; and

a sending unit 630, configured to send the feedback parameters to the signal transmit end device, so that the signal transmit end device determines N target level amplitudes based on the feedback parameters, and generates, based on the N target level amplitudes, a second PAM signal that needs to be sent to the signal receive end device, where intervals between every two adjacent target level amplitudes in the N target level amplitudes are different from each other.

The units in the signal receive end device 600 according to this embodiment of the present invention and the foregoing other operations or functions are separately for implementing a corresponding process executed by the signal receive end device in the method 100. For brevity, details are not described herein again.

Therefore, in this embodiment of the present invention, the signal receive end device feeds back information (namely, the feedback parameters) of the received first PAM signal to the signal transmit end device, so that the signal transmit end device may obtain the second PAM signal through calculation based on the feedback parameters. In other words, specific magnitude of level amplitudes of the second PAM signal can be determined during generation of a PAM signal (namely, the second PAM signal) with unequal-interval distribution.

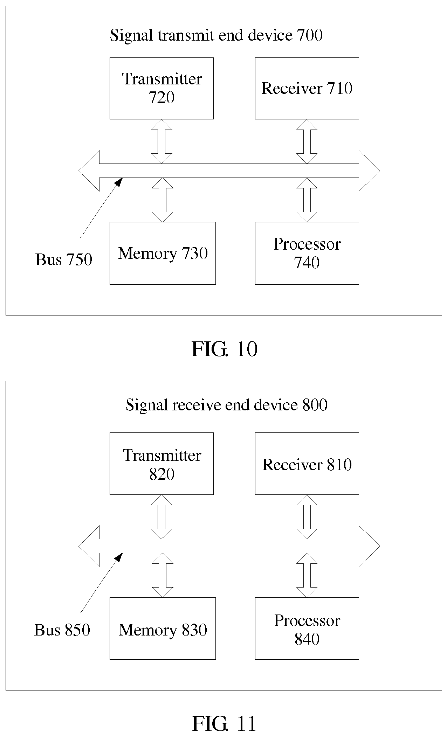

The foregoing describes the signal generation method according to the embodiments of the present invention in detail with reference to FIG. 1 to FIG. 7. The following describes a signal transmit end device and a signal receive end device according to embodiments of the present invention with reference to FIG. 10 and FIG. 11.

FIG. 10 is a schematic structural diagram of a signal transmit end device 700 according to an embodiment of the present invention. As shown in FIG. 10, the signal transmit end device 700 includes a receiver 710, a transmitter 720, a processor 740, a memory 730, and a bus system 750. The receiver 710, the transmitter 720, the processor 740, and the memory 730 are connected by using the bus system 750. The memory 730 is configured to store an instruction. The processor 740 is configured to execute the instruction stored in the memory 730, to control the receiver 710 to receive a signal and control the transmitter 720 to send a signal.

The transmitter 720 is configured to send a first PAM signal to a signal receive end device, where the first PAM signal includes N first level amplitudes, and N≥3.

The receiver 710 is configured to receive feedback parameters sent by the signal receive end device, where the feedback parameters are determined by the signal receive end device based on the first PAM signal.

The processor 740 is configured to determine N target level amplitudes based on the feedback parameters, where intervals between every two adjacent target level amplitudes in the N target level amplitudes are different from each other.

The processor 740 is further configured to generate, based on the N target level amplitudes, a second PAM signal that needs to be sent to the signal receive end device.

It should be understood that, in this embodiment of the present invention, the processor 740 may be a central processing unit (CPU), or the processor 740 may be another general purpose processor, a digital signal processor (DSP), an application-specific integrated circuit (ASIC), a field programmable gate array (FPGA) or another programmable logic device, a discrete gate or a transistor logic device, a discrete hardware component, or the like. The general purpose processor may be a microprocessor, or the processor may be any conventional processor or the like.

The memory 730 may include a read-only memory and a random access memory, and provide an instruction and data for the processor 740. A part of the memory 730 may further include a non-volatile random access memory. For example, the memory 730 may further store information of a device type.

The bus system 750 includes a power bus, a control bus, a status signal bus, and the like in addition to a data bus. However, for clarity of description, various buses are marked as the bus system 750 in the figure.

In an implementation process, steps of the foregoing method may be performed by an integrated logic circuit of hardware in the processor 740 or by an instruction in a software form. The steps of the signal generation method disclosed with reference to the embodiments of the present invention may be directly performed and completed by using a hardware processor, or may be performed and completed by using a combination of hardware in the processor and a software module. The software module may be located in a storage medium that is mature in the art, such as a random access memory, a flash memory, a read-only memory, a programmable read-only memory, an electrically erasable programmable memory, or a register. The storage medium is located in the memory 730, and the processor 740 reads information in the memory 730, and performs the steps of the foregoing method in combination with the hardware of the processor 740. To avoid repetition, details are not described herein again.

The units in the signal transmit end device 700 according to this embodiment of the present invention and the foregoing other operations or functions are separately for executing a corresponding process executed by the signal transmit end device in the method 100. For brevity, details are not described herein again.

Therefore, in this embodiment of the present invention, the signal receive end device feeds back information (namely, the feedback parameters) of the received first PAM signal to the signal transmit end device, so that the signal transmit end device may obtain the second PAM signal through calculation based on the feedback parameters. In other words, specific magnitude of level amplitudes of the second PAM signal can be determined during generation of a PAM signal (namely, the second PAM signal) with unequal-interval distribution.

FIG. 11 is a schematic structural diagram of a signal receive end device 800 according to an embodiment of the present invention. As shown in FIG. 11, the signal receive end device 800 includes a receiver 810, a transmitter 820, a processor 840, a memory 830, and a bus system 850. The receiver 810, the transmitter 820, the processor 840, and the memory 830 are connected by using the bus system 850. The memory 830 is configured to store an instruction. The processor 840 is configured to execute the instruction stored in the memory 830, to control the receiver 810 to receive a signal and control the transmitter 820 to send a signal.

The receiver 810 is configured to receive a first PAM signal sent by a signal transmit end device, where the first PAM signal includes N first level amplitudes, and N≥3.

The processor 830 is configured to determine feedback parameters based on the first PAM signal.

The transmitter 820 is configured to send the feedback parameters to the signal transmit end device, so that the signal transmit end device determines N target level amplitudes based on the feedback parameters, and generates, based on the N target level amplitudes, a second PAM signal that needs to be sent to the signal receive end device, where intervals between every two adjacent target level amplitudes in the N target level amplitudes are different from each other.

It should be understood that, in this embodiment of the present invention, the processor 840 may be a CPU, or the processor 840 may be another general purpose processor, a DSP, an ASIC, a FPGA or another programmable logic device, a discrete gate or a transistor logic device, a discrete hardware component, or the like. The general purpose processor may be a microprocessor, or the processor may be any conventional processor or the like.

The memory 830 may include a read-only memory and a random access memory, and provide an instruction and data for the processor 840. A part of the memory 830 may further include a non-volatile random access memory. For example, the memory 830 may further store information of a device type.

The bus system 850 includes a power bus, a control bus, a status signal bus, and the like in addition to a data bus. However, for clarity of description, various buses are marked as the bus system 850 in the figure.

In an implementation process, steps of the foregoing method may be performed by an integrated logic circuit of hardware in the processor 840 or by an instruction in a software form. The steps of the signal generation method disclosed with reference to the embodiments of the present invention may be directly performed and completed by using a hardware processor, or may be performed and completed by using a combination of hardware in the processor and a software module. The software module may be located in a storage medium that is mature in the art, such as a random access memory, a flash memory, a read-only memory, a programmable read-only memory, an electrically erasable programmable memory, or a register. The storage medium is located in the memory 830, and the processor 840 reads information in the memory 830, and performs the steps of the foregoing method in combination with the hardware of the processor 840. To avoid repetition, details are not described herein again.

The units in the signal receive end device 800 according to this embodiment of the present invention and the foregoing other operations or functions are separately for executing a corresponding process executed by the signal receive end device in the method 100. For brevity, details are not described herein again.

Therefore, in this embodiment of the present invention, the signal receive end device feeds back information (namely, the feedback parameters) of the received first PAM signal to the signal transmit end device, so that the signal transmit end device may obtain the second PAM signal through calculation based on the feedback parameters. In other words, specific magnitude of level amplitudes of the second PAM signal can be determined during generation of a PAM signal (namely, the second PAM signal) with unequal-interval distribution.

It should be understood that sequence numbers of the foregoing processes do not mean execution sequences in various embodiments of the present invention. The execution sequences of the processes should be determined according to functions and internal logic of the processes, and should not be construed as any limitation on the implementation processes of the embodiments of the present invention.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of the present invention may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of the present invention essentially, or the part contributing to the prior art, or some of the technical solutions may be implemented in a form of a software product. The computer software product is stored in a storage medium, and includes several instructions for instructing a computer device (which may be a personal computer, a server, or a network device) to perform all or some of the steps of the method described in the embodiments of the present invention. The foregoing storage medium includes: any medium that can store program code, such as a USB flash drive, a removable hard disk, a read-only memory (ROM), a random access memory (RAM), a magnetic disk, or an optical disc.

**Claims**

1. A signal generation method (100), wherein the method comprises:

   sending (101), by a signal transmit end device, a first PAM signal to a signal receive end device, wherein the first PAM signal comprises N first level amplitudes, and N≥3;
   receiving (103), by the signal transmit end device, feedback parameters sent by the signal receive end device, wherein the feedback parameters are determined by the signal receive end device based on the first PAM signal; **characterized by** determining (104), by the signal transmit end device, N target level amplitudes based on the feedback parameters, wherein intervals between every two adjacent target level amplitudes in the N target level amplitudes are different from each other; and
   generating (105), by the signal transmit end device based on the N target level amplitudes, a second PAM signal that needs to be sent to the signal receive end device, wherein the method is applied in a broadcast-type network, and the broadcast-type network comprises at least two signal receive end devices,
   the sending, by a signal transmit end device, a first PAM signal to a signal receive end device comprises:

   sending, by the signal transmit end device, the first PAM signal to the at least two signal receive end devices;
   the receiving, by the signal transmit end device, feedback parameters sent by the signal receive end device comprises:

   receiving, by the signal transmit end device, at least two feedback parameters sent by the at least two signal receive end devices, wherein the at least two feedback parameters correspond one-to-one to the at least two signal receive end devices; and
   the determining, by the signal transmit end device, N target level amplitudes based on the feedback parameters comprises:
   determining, by the signal transmit end device, the N target level amplitudes based on a minimum value of the at least two feedback parameters.

2. The method according to claim 1, wherein the determining, by the signal transmit end device, N target level amplitudes based on the feedback parameters comprises:

   generating, by the signal transmit end device, N reference level amplitudes based on the feedback parameters and preset parameters;
   determining, by the signal transmit end device, a quality factor between every two adjacent reference level amplitudes in the N reference level amplitudes, to obtain (N-1) quality factors; and
   when a difference between any two quality factors in the (N-1) quality factors is less than or equal to a preset threshold, determining, by the signal transmit end device, the N reference level amplitudes as the N target level amplitudes.

3. The method according to claim 1 or 2, wherein before the receiving, by the signal transmit end device, feedback parameters sent by the signal receive end device, the method further comprises:
   sending, by the signal transmit end device, a report request to the signal receive end device, wherein the report request is used to instruct the signal receive end device to report the feedback parameters.

4. The method according to any one of claims 1 to 3, wherein the feedback parameters are an average level power and an extinction ratio ER of N first levels, or the feedback parameters are a maximum level power and a minimum level power of N first levels, wherein
   the N first levels correspond one-to-one to the N first level amplitudes, and each first level amplitude is an amplitude value of a corresponding first level.

**5.** A signal transmit end device (500), wherein the device comprises:

a sending unit (510), configured to send a first PAM signal to a signal receive end device, wherein the first PAM signal comprises N first level amplitudes, and N≥3;
a receiving unit (520), configured to receive feedback parameters sent by the signal receive end device, wherein the feedback parameters are determined by the signal receive end device based on the first PAM signal; and **characterized in that** the device comprises:

a processing unit (530), configured to determine N target level amplitudes based on the feedback parameters, wherein intervals between every two adjacent target level amplitudes in the N target level amplitudes are different from each other, wherein
the processing unit is further configured to generate, based on the N target level amplitudes, a second PAM signal that needs to be sent to the signal receive end device, wherein the signal transmit end device and the signal receive end device are suitable for a broadcast-type network, and the broadcast-type network comprises at least two signal receive end devices, and
the sending unit is specifically configured to send the first PAM signal to the at least two signal receive end devices;

the receiving unit is specifically configured to receive at least two feedback parameters sent by the at least two signal receive end devices, wherein the at least two feedback parameters correspond one-to-one to the at least two signal receive end devices; and
the processing unit is specifically configured to determine the N target level amplitudes based on a minimum value of the at least two feedback parameters.

**6.** The signal transmit end device according to claim 8, wherein the processing unit is specifically configured to:

generate N reference level amplitudes based on the feedback parameters and preset parameters;
determine a quality factor between every two adjacent reference level amplitudes in the N reference level amplitudes, to obtain (N-1) quality factors; and
when a difference between any two quality factors in the (N-1) quality factors is less than or equal to a preset threshold, determine the N reference level amplitudes as the N target level amplitudes.

**7.** The signal transmit end device according to claim 8 or 9, wherein the receiving unit is specifically configured to send a report request to the signal receive end device, wherein the report request is used to instruct the signal receive end device to report the feedback parameters.

**8.** The signal transmit end device according to any one of claims 5 to 7, wherein the feedback parameters are an average level power and an extinction ratio ER of N first levels, or the feedback parameters are a maximum level power and a minimum level power of N first levels, wherein
the N first levels correspond one-to-one to the N first level amplitudes, and each first level amplitude is an amplitude value of a corresponding first level.

**9.** The signal transmit end device according to claim 8, wherein a value of N is 4, and when the feedback parameters are the average level power and the extinction ratio ER, the preset parameters are any two of extinction ratios between every two adjacent levels in the four first levels; or
when the feedback parameters are the maximum level power and the minimum level power, the preset parameters are any two of extinction ratios between every two adjacent levels in the four first levels.

**10.** A broadcast-type network comprising a signal transmit end device (500) according to any of claims 5 to 9 and at least two signal receive end devices (600), wherein the signal receive end devices comprise:

a receiving unit (610), configured to receive a first PAM signal sent by a signal transmit end device, wherein the first PAM signal comprises N first level amplitudes, and N≥3;
a processing unit (620), configured to determine feedback parameters based on the first PAM signal; and
a sending unit (630), configured to send the feedback parameters to the signal transmit end device, so that the signal transmit end device determines N target level amplitudes based on the feedback parameters, and generates, based on the N target level amplitudes, a second PAM signal that needs to be sent to the signal receive end device, wherein intervals between every two adjacent target level amplitudes in the N target level amplitudes are different from each other.

11. The broadcast-type network according to claim 10, wherein before the sending unit of the signal receive end devices sends the feedback parameters to the signal transmit end device, the receiving unit is specifically configured to receive a report request sent by the signal transmit end device, wherein the report request is used to instruct the signal receive end devices to report the feedback parameters; and
the sending unit of the signal receive end devices is specifically configured to send the feedback parameters to the signal transmit end device based on the report request.

**Patentansprüche**

1. Ein Signalerzeugungsverfahren (100), das Verfahren Folgendes umfassend:

Senden (101) eines ersten PAM-Signals durch ein Signalübertragungs-Endgerät an ein Signalempfangs-Endgerät, wobei das erste PAM-Signal N erste Niveauamplituden umfasst, und wobei $N \geq 3$ ist;
Empfangen (103) von Rückmeldungsparametern, die von dem Signalempfangs-Endgerät gesendet werden, durch das Signalübertragungs-Endgerät, wobei die Rückmeldungsparameter durch das Signalempfangs-Endgerät auf der Grundlage des ersten PAM-Signals bestimmt werden;
**gekennzeichnet durch** Bestimmen (104) von N Zielniveauamplituden auf der Grundlage der Rückmeldungsparameter durch das Signalübertragungs-Endgerät, wobei Intervalle zwischen jeweils zwei benachbarten Zielniveauamplituden in den N Zielniveauamplituden voneinander verschieden sind; und
Erzeugen (105) eines zweiten PAM-Signals, das an das Signalempfangs-Endgerät gesendet werden muss, durch das Signalübertragungs-Endgerät auf der Grundlage der N Zielniveauamplituden, wobei das Verfahren in einem Netzwerk vom Rundsendetyp angewendet wird und das Netzwerk vom Rundsendetyp mindestens zwei Signalempfangs-Endgeräte umfasst, wobei das Senden eines ersten PAM-Signals an ein Signalempfangs-Endgerät durch ein Signalübertragungs-Endgerät Folgendes umfasst:

Senden des ersten PAM-Signals durch das Signalübertragungs-Endgerät an die mindestens zwei Signalempfangs-Endgeräte;
wobei das Empfangen der vom Signalübertragungs-Endgerät gesendeten Rückmeldungsparameter durch das Signalempfangs-Endgerät Folgendes umfasst:

Empfangen von mindestens zwei Rückmeldungsparametern, die von den mindestens zwei Signalempfangs-Endgeräten gesendet werden, durch das Signalübertragungs-Endgerät, wobei die mindestens zwei Rückmeldungsparameter den mindestens zwei Signalempfangs-Endgeräten eins zu eins entsprechen; und
wobei das Bestimmen von N Zielniveauamplituden auf der Grundlage der Rückmeldungsparameter durch das Signalübertragungs-Endgerät Folgendes umfasst: Bestimmen der N Zielniveauamplituden auf der Grundlage eines Mindestwertes der mindestens zwei Rückmeldungsparameter durch das Signalübertragungs-Endgerät.

2. Verfahren nach Anspruch 1, wobei das Bestimmen von N Zielniveauamplituden auf der Grundlage der Rückmeldugsparameter durch das Signalübertragungs-Endgerät Folgendes umfasst:

Erzeugen von N Referenzniveauamplituden auf der Grundlage der Rückmeldungsparameter und voreingestellten Parameter durch das Signalübertragungs-Endgerät;
Bestimmen eines Qualitätsfaktors zwischen jeweils zwei benachbarten Bezugsniveauamplituden in den N Referenzniveauamplituden durch das Signalübertragungs-Endgerät, um (N-1) Qualitätsfaktoren zu erhalten; und
wenn eine Differenz zwischen zwei beliebigen Qualitätsfaktoren in den (N-1) Qualitätsfaktoren kleiner oder gleich einem voreingestellten Schwellenwert ist, Bestimmen der N Referenzniveauamplituden als die N Zielniveauamplituden durch das Signalübertragungs-Endgerät.

3. Verfahren nach Anspruch 1 oder 2, wobei vor dem Empfangen von Rückmeldungsparametern durch das Signalempfangs-Endgerät, die durch das Signalübertragungs-Endgerät gesendet werden, das Verfahren ferner Folgendes umfasst: Senden einer Berichtsanfrage durch das Signalübertragungs-Endgerät an das Signalempfangs-Endgerät, wobei die Berichtsanfrage dazu verwendet wird, das Signalempfangs-Endgerät anzuweisen, die Rückmeldungsparameter zu melden.

**4.** Verfahren nach einem der Ansprüche 1 bis 3, wobei die Rückmeldungsparameter eine durchschnittliche Niveauleistung und ein Extinktionsverhältnis ER von N ersten Niveaus sind, oder die Rückmeldungsparameter eine maximale Niveauleistung und eine minimale Niveauleistung von N ersten Niveaus sind, wobei die N ersten Niveaus eins zu eins den N Amplituden des ersten Niveaus entsprechen und jede Amplitude des ersten Niveaus ein Amplitudenwert eines entsprechenden ersten Niveaus ist.

**5.** Signalübertragungs-Endgerät (500), das Gerät Folgendes umfassend:

eine Sendeeinheit (510), die dafür konfiguriert ist, ein erstes PAM-Signal an ein Signalempfangs-Endgerät zu senden, wobei das erste PAM-Signal N erste Niveauamplituden umfasst, und wobei $N \geq 3$ ist;
eine Empfangseinheit (520), die dafür konfiguriert ist, Rückmeldungsparameter zu empfangen, die von dem Signalempfangs-Endgerät gesendet werden, wobei die Rückmeldungsparameter von dem Signalempfangs-Endgerät auf der Grundlage des ersten PAM-Signals bestimmt werden; und
**dadurch gekennzeichnet, dass** das Gerät Folgendes umfasst:

eine Verarbeitungseinheit (530), die dafür konfiguriert ist, N Zielniveauamplituden auf der Grundlage der Rückmeldungsparameter zu bestimmen, wobei Intervalle zwischen jeweils zwei benachbarten Zielniveauamplituden in den N Zielniveauamplituden voneinander verschieden sind, wobei die Verarbeitungseinheit ferner dafür konfiguriert ist, auf der Grundlage der N Zielniveauamplituden ein zweites PAM-Signal zu erzeugen, das an das Signalempfangs-Endgerät gesendet werden soll, wobei das Signalübertragungs-Endgerät und das Signalempfangs-Endgerät für ein Netzwerk vom Rundsendetyp geeignet sind, und das Netzwerk vom Rundsendetyp mindestens zwei Signalempfangs-Endgeräte umfasst, und die Sendeeinheit speziell dafür konfiguriert ist, das erste PAM-Signal an die mindestens zwei Signalempfangs-Endgeräte zu senden;
wobei die Empfangseinheit speziell dafür konfiguriert ist, mindestens zwei Rückmeldungsparameter zu empfangen, die von den mindestens zwei Signalempfangs-Endgeräten gesendet werden, wobei die mindestens zwei Rückmeldungsparameter den mindestens zwei Signalempfangs-Endgeräten eins zu eins entsprechen; und
wird die Verarbeitungseinheit speziell dafür konfiguriert, die N Zielniveauamplituden auf der Grundlage eines Mindestwertes der mindestens zwei Rückmeldungsparameter zu bestimmen.

**6.** Signalübertragungs-Endgerät nach Anspruch 8, wobei die Verarbeitungseinheit speziell dafür konfiguriert ist,:

N Referenzniveauamplituden auf der Grundlage der Rückmeldungsparameter und voreingestellten Parameter zu erzeugen;
einen Qualitätsfaktor zwischen jeweils zwei benachbarten Referenzniveauamplituden in den N Referenzniveauamplituden zu bestimmen, um (N-1) Qualitätsfaktoren zu erhalten; und
wenn eine Differenz zwischen zwei beliebigen Qualitätsfaktoren in den (N-1) Qualitätsfaktoren kleiner oder gleich einem voreingestellten Schwellenwert ist, die N Referenzniveauamplituden als die N Zielniveauamplituden zu bestimmen.

**7.** Signalübertragungs-Endgerät nach Anspruch 8 oder 9, wobei die Empfangseinheit speziell dafür konfiguriert ist, eine Berichtsanfrage an das Signalempfangs-Endgerät zu senden, wobei die Berichtsanfrage dazu verwendet wird, das Signalempfangs-Endgerät anzuweisen, die Rückmeldungsparameter zu melden.

**8.** Signalübertragungs-Endgerät nach einem der Ansprüche 5 bis 7, wobei die Rückmeldungsparameter eine durchschnittliche Niveauleistung und ein Extinktionsverhältnis ER von N ersten Niveaus sind, oder die Rückmeldungsparameter eine maximale Niveauleistung und eine minimale Niveauleistung von N ersten Niveaus sind, wobei die N ersten Niveaus eins zu eins den N Amplituden des ersten Niveaus entsprechen und jede Amplitude des ersten Niveaus ein Amplitudenwert eines entsprechenden ersten Niveaus ist.

**9.** Signalübertragungs-Endgerät nach Anspruch 8, wobei ein Wert von N gleich 4 ist, und wenn die Rückmeldungsparameter die durchschnittliche Niveauleistung und das Extinktionsverhältnis ER sind, sind die voreingestellten Parameter beliebige zwei von Extinktionsverhältnissen zwischen jeweils zwei benachbarten Niveaus in den vier ersten Niveaus; oder
wenn die Rückmeldungsparameter die maximale Niveauleistung und die minimale Niveauleistung sind, sind die voreingestellten Parameter zwei beliebige Extinktionsverhältnisse zwischen jeweils zwei benachbarten Niveaus in den vier ersten Niveaus.

**10.** Netzwerk vom Rundsendetyp, das ein Signalübertragungs-Endgerät (500) nach einem der Ansprüche 5 bis 9 und mindestens zwei Signalempfangs-Endgeräte (600) umfasst, wobei die Signalempfangs-Endgeräte Folgendes umfassen:

eine Empfangseinheit (610), die dafür konfiguriert ist, ein erstes PAM-Signal zu empfangen, das von einem Signalübertragungs-Endgerät gesendet wird, wobei das erste PAM-Signal N erste Niveauamplituden umfasst, und wobei N $\geq$ 3 ist;

eine Verarbeitungseinheit (620), die dafür konfiguriert ist, Rückmeldungsparameter auf der Grundlage des ersten PAM-Signals zu bestimmen; und

eine Sendeeinheit (630), die dafür konfiguriert ist, die Rückmeldungsparameter an das Signalübertragungs-Endgerät zu senden, so dass das Signalübertragungs-Endgerät N Zielniveauamplituden auf der Grundlage der Rückmeldungsparameter bestimmt und auf der Grundlage der N Zielniveauamplituden ein zweites PAM-Signal erzeugt, das an das Signalempfangs-Endgerät gesendet werden soll, wobei Intervalle zwischen jeweils zwei benachbarten Zielniveauamplituden in den N Zielniveauamplituden voneinander verschieden sind.

**11.** Netzwerk vom Rundsendetyp nach Anspruch 10, wobei, bevor die Sendeeinheit der Signalempfangs-Endgeräte die Rückmeldungsparameter an das Signalübertragungs-Endgerät sendet, die Empfangseinheit speziell dafür konfiguriert ist, eine von dem Signalübertragungs-Endgerät gesendete Berichtsanfrage zu empfangen, wobei die Berichtsanfrage dazu verwendet wird, die Signalempfangs-Endgeräte anzuweisen, die Rückmeldungsparameter zu melden; und

wobei die Sendeeinheit der Signalempfangs-Endgeräte speziell dafür konfiguriert ist, die Rückmeldungsparameter auf der Grundlage der Berichtsanfrage an das Signalübertragungs-Endgerät zu senden.


**Revendications**

**1.** Procédé de production de signal (100), le procédé comprenant :

l'envoi (101), par un dispositif terminal d'émission de signal, d'un premier signal PAM à un dispositif terminal de réception de signal, le premier signal PAM comprenant N amplitudes de premier niveau, et N$\geq$3 ;

la réception (103), par le dispositif terminal d'émission de signal, de paramètres de rétroaction envoyés par le dispositif terminal de réception de signal, les paramètres de rétroaction étant déterminés par le dispositif terminal de réception de signal en fonction du premier signal PAM ;

**caractérisé par** la détermination (104), par le dispositif terminal d'émission de signal, de N amplitudes de niveau cible en fonction des paramètres de rétroaction, les intervalles entre deux amplitudes de niveau cible adjacentes des N amplitudes de niveau cible étant différents les uns des autres ; et

la production (105), par le dispositif terminal d'émission de signal en fonction des N amplitudes de niveau cible, d'un second signal PAM qui doit être envoyé au dispositif terminal de réception de signal, le procédé étant appliqué dans un réseau de type diffusion et le réseau de type diffusion comprenant au moins deux dispositifs terminaux de réception de signal, l'envoi, par un dispositif terminal d'émission de signal, d'un premier signal PAM à un dispositif terminal de réception de signal comprenant :

l'envoi, par le dispositif terminal d'émission de signal, du premier signal PAM aux au moins deux dispositifs terminaux de réception de signal ;

la réception, par le dispositif terminal d'émission de signal, de paramètres de rétroaction envoyés par le dispositif terminal de réception de signal, ladite réception comprenant :

la réception, par le dispositif terminal d'émission de signal, d'au moins deux paramètres de rétroaction envoyés par les au moins deux dispositifs terminaux de réception de signal, les au moins deux paramètres de rétroaction correspondant avec biunivocité aux au moins deux dispositifs terminaux de réception de signal ; et

la détermination, par le dispositif terminal d'émission de signal, de N amplitudes de niveau cible en fonction des paramètres de rétroaction, ladite détermination comprenant :

la détermination, par le dispositif terminal d'émission de signal, des N amplitudes de niveau cible en fonction d'une valeur minimale des au moins deux paramètres de rétroaction.

**2.** Procédé selon la revendication 1, dans lequel la détermination, par le dispositif terminal d'émission de signal, de N amplitudes de niveau cible en fonction des paramètres de rétroaction comprend :

la production, par le dispositif terminal d'émission de signal, de N amplitudes de niveau de référence en fonction des paramètres de rétroaction et des paramètres prédéfinis ;

la détermination, par le dispositif terminal d'émission de signal, d'un facteur de qualité entre deux amplitudes de niveau de référence adjacentes des N amplitudes de niveau de référence, pour obtenir (N-1) facteurs de qualité ; et

le fait de déterminer, grâce au dispositif terminal d'émission de signal, lorsqu'une différence entre deux facteurs de qualité des (N-1) facteurs de qualité est inférieure ou égale à un seuil prédéfini, que les N amplitudes de niveau de référence forment N amplitudes de niveau cible.

3. Procédé selon la revendication 1 ou 2, comprenant en outre, avant la réception, par le dispositif terminal d'émission de signal, des paramètres de rétroaction envoyés par le dispositif terminal de réception de signal :

l'envoi, par le dispositif terminal d'émission de signal, d'une demande de signalement au dispositif terminal de réception de signal, la demande de signalement servant à ordonner au dispositif terminal de réception de signal de signaler les paramètres de rétroaction.

4. Procédé selon l'une quelconque des revendications 1 à 3, dans lequel les paramètres de rétroaction sont une puissance de niveau moyen et un rapport d'extinction ER de N premiers niveaux, ou dans lequel les paramètres de rétroaction sont une puissance de niveau maximal et une puissance de niveau minimal de N premiers niveaux, les N premiers niveaux correspondant avec biunivocité aux N premières amplitudes de niveau et chaque première amplitude de niveau étant une valeur d'amplitude d'un premier niveau correspondant.

5. Dispositif terminal d'émission de signal (500), le dispositif comprenant :

une unité d'envoi (510) configurée pour envoyer un premier signal PAM à un dispositif terminal de réception de signal, le premier signal PAM comprenant N amplitudes de premier niveau, et $N \geq 3$ ;

une unité de réception (520) configurée pour recevoir des paramètres de rétroaction envoyés par le dispositif terminal de réception de signal, les paramètres de rétroaction étant déterminés par le dispositif terminal de réception de signal en fonction du premier signal PAM ; et

**caractérisé en ce que** le dispositif comprend :

une unité de traitement (530) configurée pour déterminer N amplitudes de niveau cible en fonction des paramètres de rétroaction, les intervalles entre deux amplitudes de niveau cible adjacentes des N amplitudes de niveau cible étant différents les uns des autres, l'unité de traitement étant en outre configurée pour générer, en fonction des N amplitudes de niveau cible, un second signal PAM qui doit être envoyé au dispositif terminal de réception de signal, le dispositif terminal d'émission de signal et le dispositif terminal de réception de signal étant adaptés pour un réseau de type diffusion et le réseau de type diffusion comprenant au moins deux dispositifs terminaux de réception de signal, tandis que l'unité d'envoi est spécifiquement configurée pour envoyer le premier signal PAM aux au moins deux dispositifs terminaux de réception de signal ;

l'unité de réception étant spécifiquement configurée pour recevoir au moins deux paramètres de rétroaction envoyés par les au moins deux dispositifs terminaux de réception de signal, les au moins deux paramètres de rétroaction correspondant avec biunivocité aux au moins deux dispositifs terminaux de réception de signal ; et

l'unité de traitement étant spécifiquement configurée pour déterminer les N amplitudes de niveau cible en fonction d'une valeur minimale des au moins deux paramètres de rétroaction.

6. Dispositif terminal d'émission de signal selon la revendication 8, dans lequel l'unité de traitement est spécifiquement configurée pour :

générer N amplitudes de niveau de référence en fonction des paramètres de rétroaction et des paramètres prédéfinis ;

déterminer un facteur de qualité entre toutes les deux amplitudes de niveau de référence adjacentes des N amplitudes de niveau de référence, pour obtenir (N-1) facteurs de qualité ; et

déterminer, lorsqu'une différence entre deux facteurs de qualité des (N-1) facteurs de qualité est inférieure ou égale à un seuil prédéfini, que les N amplitudes de niveau de référence forment N amplitudes de niveau cible.

7. Dispositif terminal d'émission de signal selon la revendication 8 ou 9, dans lequel l'unité de réception est spécifiquement configurée pour envoyer une demande de signalement au dispositif terminal de réception de signal, la demande de signalement servant à ordonner au dispositif terminal de réception de signal de signaler les paramètres de rétroaction.

8. Dispositif terminal d'émission de signal selon l'une quelconque des revendications 5 à 7, dans lequel les paramètres de rétroaction représentent une puissance de niveau moyen et un rapport d'extinction ER de N premiers niveaux, ou dans lequel les paramètres de rétroaction représentent une puissance de niveau maximal et une puissance de niveau minimal de N premiers niveaux, les N premiers niveaux correspondant avec biunivocité aux N premières amplitudes de niveau et chaque première amplitude de niveau étant une valeur d'amplitude d'un premier niveau correspondant.

9. Dispositif terminal d'émission de signal selon la revendication 8, dans lequel une valeur de N est 4, et dans lequel, lorsque les paramètres de rétroaction sont la puissance de niveau moyen et le rapport d'extinction ER, les paramètres prédéfinis représentent deux rapports d'extinction entre deux niveaux adjacents des quatre premiers niveaux ; ou lorsque les paramètres de rétroaction représentent la puissance de niveau maximal et la puissance de niveau minimal, les paramètres prédéfinis représentent deux rapports d'extinction entre deux niveaux adjacents des quatre premiers niveaux.

10. Réseau de type diffusion comprenant un dispositif terminal d'émission de signal (500) selon l'une quelconque des revendications 5 à 9 et au moins deux dispositifs terminaux de réception de signal (600), les dispositifs terminaux de réception de signal comprenant :

une unité de réception (610) configurée pour recevoir un premier signal PAM envoyé par un dispositif terminal d'émission de signal, le premier signal PAM comprenant N amplitudes de premier niveau et $N \geq 3$ ;
une unité de traitement (620) configurée pour déterminer des paramètres de rétroaction en fonction du premier signal PAM ; et
une unité d'envoi (630) configurée pour envoyer les paramètres de rétroaction au dispositif terminal d'émission de signal, afin que le dispositif terminal d'émission de signal détermine N amplitudes de niveau cible en fonction des paramètres de rétroaction et génère, en fonction des N amplitudes de niveau cible, un second signal PAM à envoyer au dispositif terminal de réception de signal, les intervalles entre deux amplitudes adjacentes de niveau cible des N amplitudes de niveau cible étant différents les uns des autres.

11. Réseau de type diffusion selon la revendication 10, dans lequel, avant que l'unité d'envoi des dispositifs terminaux de réception de signal envoie les paramètres de rétroaction au dispositif terminal d'émission de signal, l'unité de réception est spécifiquement configurée pour recevoir une demande de signalement envoyée par le dispositif terminal d'émission de signal, la demande de signalement servant à ordonner aux dispositifs terminaux de réception de signal de signaler les paramètres de rétroaction ; et
l'unité d'envoi des dispositifs terminaux de réception de signal étant spécifiquement configurée pour envoyer les paramètres de rétroaction au dispositif terminal d'émission de signal en fonction de la demande de signalement.

100

```
┌─────────────────────┐              ┌─────────────────────┐
│  Signal transmit end │              │  Signal receive end  │
│        device        │              │        device        │
└─────────────────────┘              └─────────────────────┘
          │                                    │
          │    101. Send a first PAM signal    │
          │───────────────────────────────────▶│
          │                                    │
          │              ┌──────────────────────────────────┐
          │              │   102. Determine feedback         │
          │              │   parameters based on the first   │
          │              │        PAM signal                 │
          │              └──────────────────────────────────┘
          │                                    │
          │   103. Send the feedback parameters │
          │◀───────────────────────────────────│
          │                                    │
┌──────────────────────────────┐              │
│  104. Determine N target level│              │
│   amplitudes based on the     │              │
│      feedback parameters      │              │
└──────────────────────────────┘              │
          │                                    │
┌──────────────────────────────┐              │
│   105. Generate a second PAM  │              │
│  signal based on the N target │              │
│       level amplitudes        │              │
└──────────────────────────────┘              │
          │                                    │
```

FIG. 1

Equal-interval distribution      Unequal-interval distribution

FIG. 2

FIG. 3

FIG. 4

FIG. 5

FIG. 6

FIG. 7

Signal transmit end device 500

Sending unit 510

Receiving unit 520

Processing unit 530

FIG. 8

Signal receive end device 600

Receiving unit 610

Processing unit 620

Sending unit 630

FIG. 9

Signal transmit end device 700

Transmitter 720

Receiver 710

Bus 750

Memory 730

Processor 740

FIG. 10

Signal receive end device 800

Transmitter 820

Receiver 810

Bus 850

Memory 830

Processor 840

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2003180055 A
- WO 2014130386 A
- EP 2421280 A